# EUROPEAN PATENT APPLICATION

(11) **EP 4 811 345 A1**
(43) Date of publication of application: **23.09.2026**
(21) Application number: 26166003.9
(22) Date of filing: 19.03.2026
(51) Int. Cl.: G09G 3/34

(54) **DISPLAY DEVICE AND DRIVING METHOD THEREOF**

(30) Priority: 19.03.2025 US 202563774111 P
(71) Applicant: E Ink Holdings Inc., 30078 Hsinchu (TW)
(72) Inventor: CHEN, Yu-Wei, Hsinchu (TW); HUANG, Wei-Kai, Hsinchu (TW)
(74) Representative: Becker, Eberhard

(57) **Abstract**

A display device (100) and a driving method thereof are provided. The display device (100) includes a pixel array (110) including a plurality of pixel units (P(1,1) to P(M,N)). Each pixel unit (P(1,1) to P(M,N)) includes a first bootstrap capacitor (Cboost1), a second bootstrap capacitor (Cboost2), a storage capacitor (Cst), a first transistor (T1), a second transistor (T2), a third transistor (T3), a fourth transistor (T4), and a fifth transistor (T5). The first bootstrap capacitor (Cboost1) and first transistor (T1) are coupled to a first node (N1). The second bootstrap capacitor (Cboost2) is coupled to the first node (N1) and a second node (N2). The storage capacitor (Cst) is coupled to the second node (N2). The second transistor (T2) is coupled to the first bootstrap capacitor (Cboost1).

## Description

### BACKGROUND

### Technical Field

The invention relates to a device, and particularly relates to a display device and a driving method thereof.

### Description of Related Art

Thin film transistor switches in conventional pixel circuits need to be controlled through gate drive signals (gate voltages). When writing data signals (data voltages), the gate voltage needs to be greater than the data voltage to write the data signal into the pixel circuit to drive the display unit. For this reason, the conventional pixel circuit needs to provide gate drive signals with high voltage levels through high voltage driving systems, thereby resulting in increased system costs.

### SUMMARY

The invention provides a display device and a driving method thereof having good display driving capability.

The display device of the present invention includes a pixel array. The pixel array includes a plurality of pixel units. Each of the plurality of pixel units includes a first bootstrap capacitor, a second bootstrap capacitor, a storage capacitor, a first transistor, a second transistor, a third transistor, a fourth transistor, and a fifth transistor. The first bootstrap capacitor is coupled to a first node. The second bootstrap capacitor is coupled to the first node and a second node. The storage capacitor is coupled to the second node. The first transistor is coupled to the first node. The second transistor is coupled to the first bootstrap capacitor. The third transistor is coupled to a second terminal of the first transistor, the second transistor, and the first bootstrap capacitor. The fourth transistor is coupled to the second node and the storage capacitor. The fifth transistor is coupled to the first transistor, a first terminal of the third transistor, and the second node. The pixel unit is configured to perform in an update operation: during a charging period, writing a data voltage into the first node; during a first boost period, switching one terminal of the first bootstrap capacitor from a reference voltage to the data voltage, and causing a first boost or pull-down of the pixel voltage of the first node through capacitive coupling; during a second boost period, switching one terminal of the second bootstrap capacitor from a reference voltage to the data voltage, and causing a second boost or pull-down of the pixel voltage of the first node through capacitive coupling; and during a maintain period, maintaining the pixel voltage of the first node.

The driving method of the present invention is applied to a display device including a pixel array. The pixel array includes a plurality of pixel units. Each of the plurality of pixel units includes a first node, a second node, a first bootstrap capacitor, a second bootstrap capacitor, and a storage capacitor. The driving method includes performing an update operation on each of the plurality of pixel units. The update operation includes the following steps: during a charging period, enabling a first gate drive signal to write a data voltage into the first node; during a first boost period, enabling a second gate drive signal and setting a data signal line to a fixed voltage to switch one terminal of the first bootstrap capacitor from a reference voltage to the data voltage, and causing a first boost or pull-down of the pixel voltage of the first node through capacitive coupling; during a second boost period, enabling a third gate drive signal and maintaining the data signal line at the fixed voltage to switch one terminal of the second bootstrap capacitor from a reference voltage to the data voltage, and causing a second boost or pull-down of the pixel voltage of the first node through capacitive coupling; and during a maintain period, turning off the first gate drive signal, the second gate drive signal, and the third gate drive signal to maintain the pixel voltage of the first node.

Based on the above, the display device and driving method thereof of the invention may effectively generate the pixel voltages applied to display units driven by high voltage.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a schematic diagram of a display device according to an embodiment of the invention.
FIG. 2 is a schematic diagram of a pixel circuit according to an embodiment of the invention.
FIG. 3 is a timing diagram of multiple signals and voltages according to the embodiment of FIG. 2 of the invention.
FIG. 4 is a flowchart of a driving method according to an embodiment of the invention.
FIG. 5A is a schematic diagram of a pixel circuit according to an embodiment of the invention.
FIG. 5B is a timing diagram of multiple signals and voltages according to the embodiment of FIG. 5A of the invention.
FIG. 5C is a flowchart of a driving method according to the embodiment of FIG. 5A of the invention.
FIG. 6A is a schematic diagram of a pixel circuit according to another embodiment of the invention.
FIG. 6B is a timing diagram of multiple signals and voltages according to the embodiment of FIG. 6A of the invention.
FIG. 6C is a flowchart of a driving method according to the embodiment of FIG. 6A of the invention.
FIG. 6D is another timing diagram of multiple signals and voltages according to the embodiment of FIG. 6A of the invention.
FIG. 7 is a schematic diagram of a gate driver circuit according to an embodiment of the invention.
FIG. 8 is a schematic diagram of a gate driver according to an embodiment of the invention.
FIG. 9 is a timing diagram of multiple clock signals and multiple gate drive signals according to the embodiment of FIG. 7 of the invention.

### DESCRIPTION OF THE EMBODIMENTS

In order to make the content of the present invention more easily understood, the following specific embodiments are provided as examples that the present invention may indeed be implemented accordingly. In addition, wherever possible, elements/components/steps using the same reference numerals in the drawings and embodiments represent the same or similar parts.

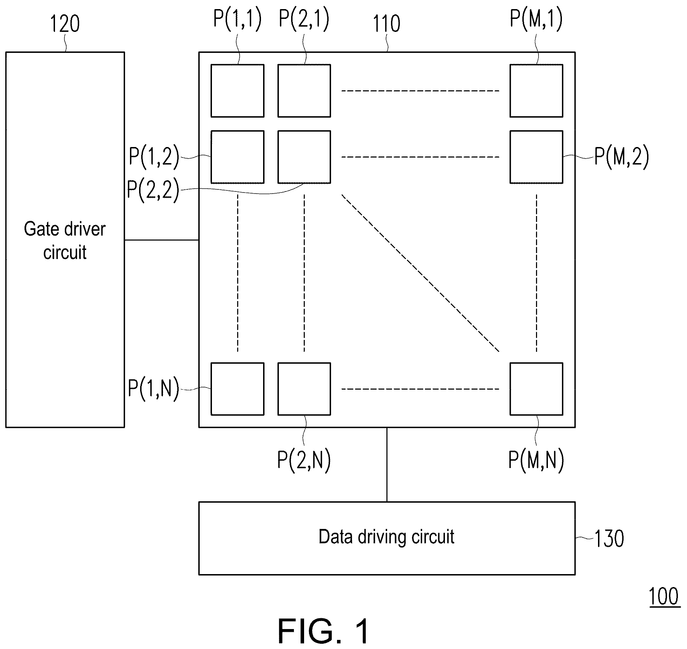

FIG. 1 is a schematic diagram of a display device according to an embodiment of the invention. Referring to FIG. 1, the display device 100 includes a pixel array 110, a gate driver circuit 120, and a data driving circuit 130 (also referred to as a source driver circuit). The pixel array 110 is coupled to the gate driver circuit 120 and the data driving circuit 130. The pixel array 110 includes a plurality of pixel units P(1,1) to P(M,N), where M and N are positive integers. The gate driver circuit 120 may be coupled to the pixel units P(1,1) to P(M,N) through a plurality of gate signal lines. The data driving circuit 130 may be coupled to the pixel units P(1,1) to P(M,N) through a plurality of data signal lines (also referred to as source signal lines). In one embodiment, the display device 100 may be a bistable display, such as an electrophoretic display (EPD). In one embodiment, the display device 100 is an electronic paper display. Each of the pixel units P(1,1) to P(M,N) may include a display element, such as a microcapsule or a microcup.

In one embodiment, the pixel array 110 may be a thin film transistor (TFT) array. Each of the pixel units P(1,1) to P(M,N) includes a pixel circuit, where the pixel circuit is formed on a glass substrate. The pixel circuit is configured to generate a voltage according to at least one gate drive signal and at least one data signal (also referred to as a source drive signal) to drive a corresponding display element. In one embodiment, the gate driver circuit 120 includes a plurality of gate drivers, and the plurality of gate drivers are formed on the glass substrate in a gate on array (GOA) manner. The pixel array 110 and the gate driver circuit 120 may be formed on the same glass substrate. In one embodiment, the plurality of gate drivers may be respectively coupled to a plurality of pixel units in different rows.

In addition, in the description of the following embodiments, the first terminal and the second terminal of the transistor may be a drain terminal or a source terminal respectively, and the control terminal of the transistor may be a gate terminal, but the invention is not limited thereto. The polarity of each terminal of the transistor may be determined according to different transistor types.

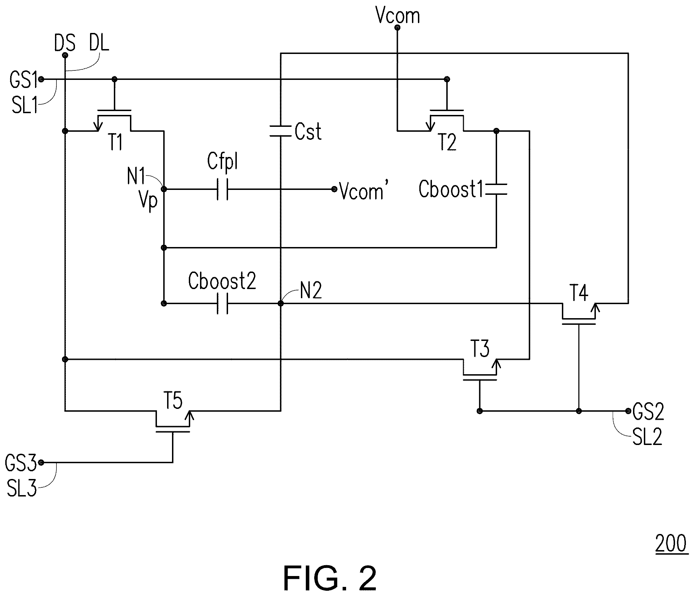

FIG. 2 is a schematic diagram of a pixel circuit according to an embodiment of the invention. Referring to FIG. 2, in one embodiment, each of the pixel units P(1,1) to P(M,N) in FIG. 1 may have the circuit architecture of the pixel circuit 200 as shown in FIG. 2. The pixel circuit 200 includes bootstrap capacitors Cboost1, Cboost2, a storage capacitor Cst, a pixel capacitor Cfpl, and transistors T1 to T5. The transistors T1 to T5 are N-type transistors, but the invention is not limited thereto. In other embodiments, the transistors T1 to T5 may also be implemented as P-type transistors.

The first terminal of the bootstrap capacitor Cboost1 is coupled to the first terminal of the transistor T2 and the second terminal of the transistor T3. The second terminal of the bootstrap capacitor Cboost1 is coupled to the first node N1. The first terminal of the bootstrap capacitor Cboost2 is coupled to the node N1. The second terminal of the bootstrap capacitor Cboost2 is coupled to the node N2. The first terminal of the storage capacitor Cst is coupled to the second terminal of the transistor T4. The second terminal of the storage capacitor Cst is coupled to the node N2. The first terminal of the pixel capacitor Cfpl is coupled to the node N1. The second terminal of the pixel capacitor Cfpl receives a reference voltage Vcom'.

The first terminal of the transistor T1 is coupled to the node N1. The second terminal of the transistor T1 is coupled to the data signal line DL. The control terminal of the transistor T1 is coupled to the gate signal line SL1. The first terminal of the transistor T2 is coupled to the first terminal of the bootstrap capacitor Cboost1 and the second terminal of the transistor T3. The second terminal of the transistor T2 receives a reference voltage Vcom. The control terminal of the transistor T2 is coupled to the gate signal line SL1. The first terminal of the transistor T3 is coupled to the data signal line DL. The second terminal of the transistor T3 is coupled to the first terminal of the transistor T2 and the first terminal of the bootstrap capacitor Cboost1. The control terminal of the transistor T3 is coupled to the gate signal line SL2. The first terminal of the transistor T4 is coupled to the node N2. The second terminal of the transistor T4 is coupled to the first terminal of the storage capacitor Cst. The control terminal of the transistor T4 is coupled to the gate signal line SL2. The first terminal of the transistor T5 is coupled to the data signal line DL. The second terminal of the transistor T5 is coupled to the node N2. The control terminal of the transistor T5 is coupled to the gate signal line SL3. The gate signal line SL1, the gate signal line SL2, and the gate signal line SL3 are respectively configured to transmit different gate drive signals.

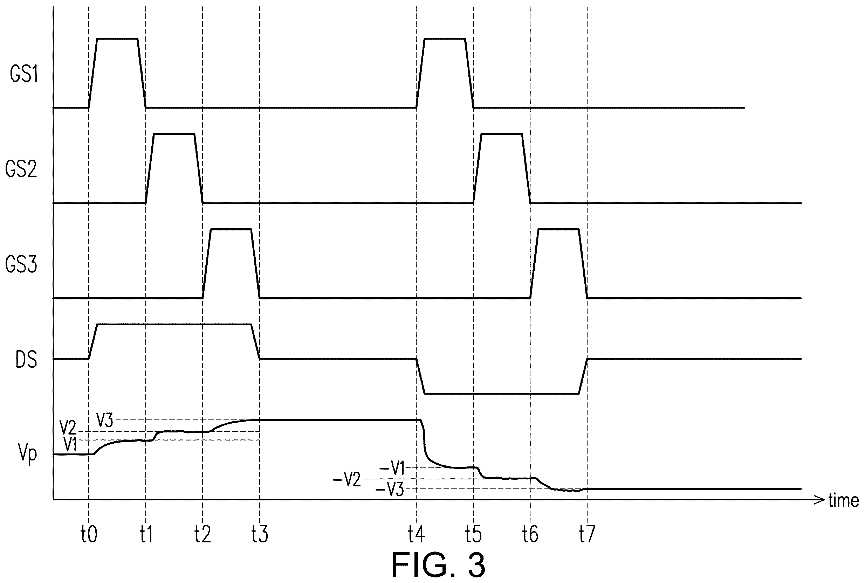

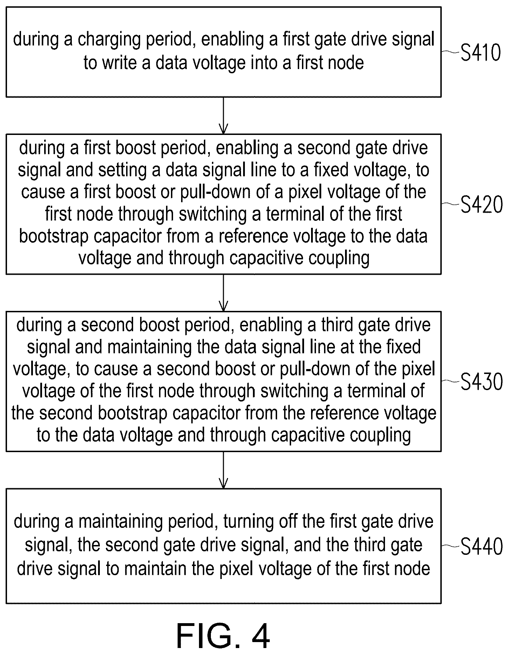

FIG. 3 is a timing diagram of multiple signals and voltages according to the embodiment of FIG. 2 of the invention. FIG. 4 is a flowchart of a driving method according to an embodiment of the invention. First referring to FIG. 1, the driving method of the display device 100 of the invention includes performing an update operation on each pixel unit of the pixel array 110, and the driving method of FIG. 4 may be applied to the display device 100 including the pixel array 110, wherein the driving method includes performing an update operation on each of the pixel units P(1,1) to P(M,N) of the pixel array 110. In this regard, referring to FIG. 2 to FIG. 4, the pixel circuit 200 may execute steps S410 to S440 as shown in FIG. 4 to implement the pixel voltage Vp variation of the embodiment of FIG. 3. In the embodiment, the gate signal line SL1 is configured to transmit the gate drive signal GS1. The gate signal line SL2 is configured to transmit the gate drive signal GS2. The gate signal line SL3 is configured to transmit the gate drive signal GS3. It should be noted that the pulse periods of the gate drive signals GS1 to GS3 are respectively non-overlapping. During the period from time t0 to time t3, the data signal DS may provide a data voltage with a positive voltage level.

In step S410, during the charging period from time t0 to time t1, the data driving circuit may enable the gate drive signal GS1 (i.e., the first gate drive signal) to write the data voltage of the data signal DS (e.g., the positive voltage V1) into node N1 (i.e., the first node). In detail, the gate drive signal GS1 is switched to a high voltage level to operate transistors T1 and T2 in a conduction state, and transistors T3 to T5 are operated in a turn-off state, so that the data signal DS charges the bootstrap capacitors Cboost1 and Cboost2, and causes the pixel voltage Vp provided by node N1 to rise to the positive voltage V1. The voltage at the second terminal of the bootstrap capacitor Cboost1 is the positive voltage V1.

In step S420, during the first boosting period from time t1 to time t2, the data driving circuit may enable the gate drive signal GS2 (i.e., the second gate drive signal) and set the data signal line DL to a fixed voltage, to cause a first boost of the pixel voltage Vp at node N1 through capacitive coupling by switching one terminal of the bootstrap capacitor Cboost1 (i.e., the first bootstrap capacitor) from the reference voltage Vcom to the data voltage. In detail, the gate drive signal GS2 switches to a high voltage level to operate transistors T3 and T4 in a conduction state, and transistors T1 to T2 and T5 are operated in a turn-off state, so that the data signal DS charges the first terminal of the bootstrap capacitor Cboost1, and the pixel voltage Vp provided by node N1 further rises to the positive voltage V2 via capacitive coupling effect. Moreover, the first terminal of the bootstrap capacitor Cboost2 is charged to the reference voltage Vcom. It should be noted that the reference voltage Vcom includes at least one common potential and/or one bias potential, and the reference voltage Vcom is used to provide to the bootstrap capacitors Cboost1 and Cboost2 at the switching terminals during each boosting period.

In step S430, during the second boosting period from time t2 to time t3, the data driving circuit may enable the gate drive signal GS3 (i.e., the third gate drive signal) and maintain the data signal line DL at the fixed voltage, to cause a second boost of the pixel voltage Vp at node N1 through capacitive coupling by switching one terminal of the bootstrap capacitor Cboost2 (i.e., the second bootstrap capacitor) from the reference voltage Vcom to the data voltage. In detail, the gate drive signal GS3 switches to a high voltage level to operate transistor T5 in a conduction state, and transistors T1 to T4 are operated in a turn-off state, so that the data signal DS charges the first terminal of the bootstrap capacitor Cboost2, and the pixel voltage Vp provided by node N1 further rises to the positive voltage V3 via capacitive coupling effect.

In step S440, during the maintaining period from time t3 to time t4, the data driving circuit may turn off the gate drive signals GS1 to GS3 to maintain the pixel voltage at node N1. In detail, the gate drive signals GS1 to GS3 switch to a low voltage level, and the pixel voltage Vp provided by node N1 may be maintained at the positive voltage V3. It should be noted that when the data voltage is positive, as shown in FIG. 3, the aforementioned first boost and second boost may increase the pixel voltage Vp. Moreover, after the second boost, the absolute value of the pixel voltage Vp is greater than the absolute value of the data voltage.

By analogy, during the period from time t4 to time t7, the data signal DS may provide a data voltage with a negative voltage level. During the charging period from time t4 to time t5, the data driving circuit may enable the gate drive signal GS1 to write the data voltage of the data signal DS (e.g., the negative voltage -V1) into node N1. In detail, during the period from time t4 to time t5, the gate drive signal GS1 is switched to a high voltage level to operate transistor T1 and transistor T2 in a conduction state, and transistors T3 to T5 are operated in a turn-off state, so that the data signal DS charges the bootstrap capacitors Cboost1, Cboost2, and causes the pixel voltage Vp provided by node N1 to drop to the negative voltage -V1. The voltage at the second terminal of the bootstrap capacitor Cboost1 is the negative voltage -V1.

During the first boosting period from time t5 to time t6, the data driving circuit may enable the gate drive signal GS2 and set the data signal line DL to a fixed voltage to cause a first pull-down of the pixel voltage Vp at node N1 through switching one terminal of the bootstrap capacitor Cboost1 from the reference voltage Vcom to the data voltage, and through capacitive coupling. In detail, the gate drive signal GS2 is switched to a high voltage level to operate transistor T3 and transistor T4 in a conduction state, and transistors T1 to T2, T5 are operated in a turn-off state, so that the data signal DS charges the first terminal of the bootstrap capacitor Cboost1, and through capacitive coupling effect causes the pixel voltage Vp provided by node N1 to further drop to the negative voltage -V2. Moreover, the first terminal of the bootstrap capacitor Cboost2 is charged to the reference voltage Vcom.

During the second boosting period from time t6 to time t7, the data driving circuit may enable the gate drive signal GS3 and maintain the data signal line DL at the fixed voltage to cause a second pull-down of the pixel voltage Vp at node N1 through switching one terminal of the bootstrap capacitor Cboost2 from the reference voltage Vcom to the data voltage, and through capacitive coupling. In detail, the gate drive signal GS3 is switched to a high voltage level to operate transistor T5 in a conduction state, and transistors T1 to T4 are operated in a turn-off state, so that the data signal DS charges the first terminal of the bootstrap capacitor Cboost2, and through capacitive coupling effect causes the pixel voltage Vp provided by node N1 to further drop to the negative voltage -V3.

During the maintaining period after time t7, the data driving circuit may turn off the gate drive signals GS1 to GS3 to maintain the pixel voltage at node N1. In detail, the gate drive signals GS1 to GS3 are switched to low voltage levels, and the pixel voltage Vp provided by node N1 may be maintained at the negative voltage -V3. It should be noted that when the data voltage is negative, as shown in FIG. 3, the aforementioned first pull-down and second pull-down may reduce the pixel voltage Vp. Moreover, after the second pull-down, the absolute value of the pixel voltage Vp is greater than the absolute value of the data voltage.

Additionally, in one embodiment, the pixel circuit 200 may also repeat the aforementioned capacitive coupling step to achieve three or more voltage boosts or voltage pull-downs. The pixel unit of the pixel circuit 200 may be configured to repeatedly execute the aforementioned capacitive coupling boosting to form at least three voltage boosts or voltage pull-downs. Therefore, the pixel circuit 200 may achieve generating pixel voltage with higher voltage level using data voltage with lower voltage level.

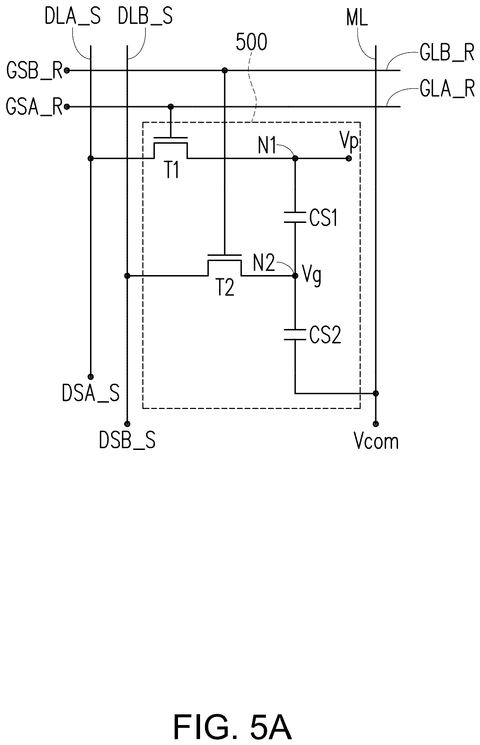

FIG. 5A is a schematic diagram of a pixel circuit according to an embodiment of the invention. Referring to FIG. 5A, in one embodiment, each of the pixel units P(1,1) to P(M,N) in FIG. 1 may have the circuit architecture of the pixel circuit 500 as shown in FIG. 5A. The pixel unit P(S,R) may include the pixel circuit 500, where S is a positive integer between 1 and M, and R is a positive integer between 1 and N. The pixel circuit 500 includes transistors T1 and T2, and capacitors CS1 and CS2. A first terminal of the transistor T1 is coupled to the data signal line DLA_S to receive the data signal DSA_S. A second terminal of the transistor T1 is coupled to the node N1. The node N1 is used to provide the pixel voltage Vp to the display unit. A control terminal of the transistor T1 is coupled to the gate signal line GLA_R to receive the gate drive signal GSA_R. A first terminal of the transistor T2 is coupled to the data signal line DLB_S to receive the data signal DSB_S. A second terminal of the transistor T2 is coupled to the node N2. The node N2 has a node voltage Vg. A control terminal of the transistor T2 is coupled to the gate signal line GLB_R to receive the gate drive signal GSB_R. The transistors T1, T2 are N-type transistors, but the present invention is not limited thereto. In other embodiments, the transistors T1, T2 may also be designed as P-type transistors. A first terminal of the capacitor CS1 is coupled to the node N1. A second terminal of the capacitor CS1 is coupled to the node N2. A first terminal of the capacitor CS2 is coupled to the node N2. A second terminal of the capacitor CS2 is coupled to the reference signal line ML to receive the reference voltage Vcom. The reference voltage Vcom may be a common electrode voltage.

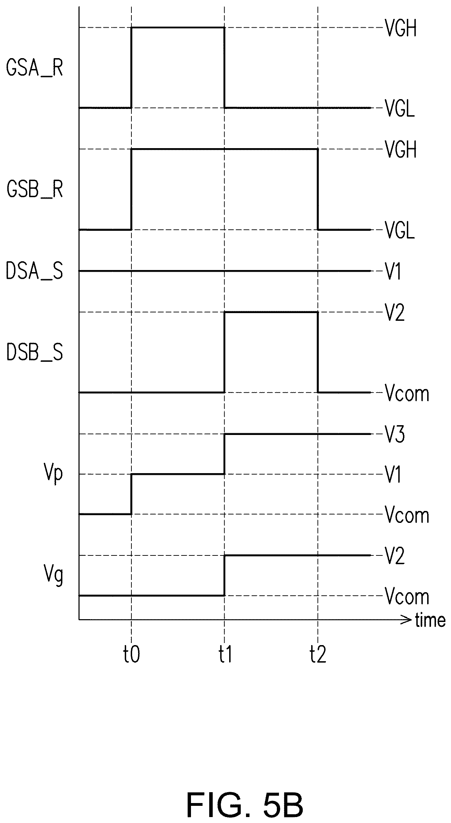

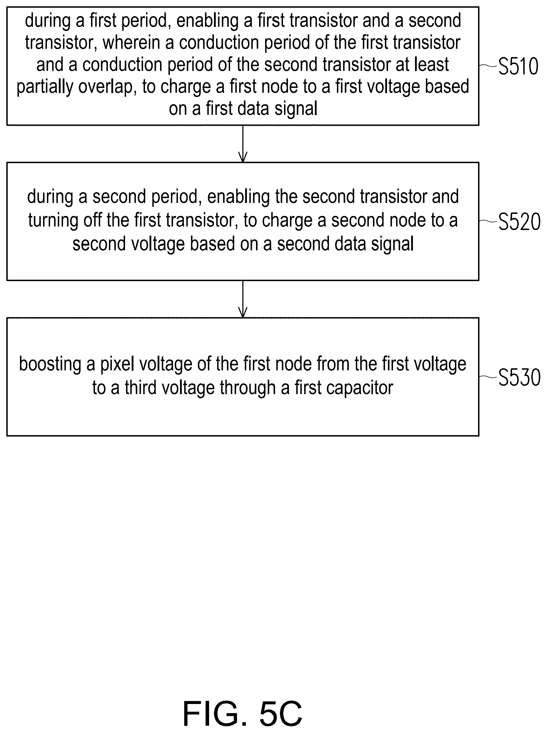

FIG. 5B is a timing diagram of multiple signals and voltages according to the embodiment of FIG. 5A of the invention. FIG. 5C is a flowchart of a driving method according to the embodiment of FIG. 5A of the invention. Referring to FIG. 5A to FIG. 5C, the pixel circuit 500 may generate the voltage variation of the pixel voltage Vp as shown in FIG. 5B based on the drive method of the embodiment of the FIG. 5C. In step S510, during the period from time t0 to time t1 (i.e., the first period), the gate driver circuit enables the transistor T1 (i.e., the first transistor) and the transistor T2 (i.e., the second transistor), where the conduction period of the transistor T1 and the conduction period of the transistor T2 at least partially overlap, to charge the node N1 (i.e., the first node) to the voltage V1 (i.e., the first voltage) according to the data signal DSA_S (i.e., the first data signal). In detail, during the period from time t0 to time t1, the gate drive signal GSA_R and the gate drive signal GSB_R are respectively switched from the low voltage level VGL to the high voltage level VGH, so that the transistors T1, T2 are operated in the conduction state. In this regard, during the period from time t0 to time t1, the conduction period of the transistor T1 and the conduction period of the transistor T2 may at least partially overlap. During the period from time t0 to time t1, the data signal DSA_S is the voltage V1, and the data signal DSB_S is the reference voltage Vcom. As such, the pixel voltage Vp provided by the node N1 may be charged to the voltage V1 based on the data signal DSA_S.

In step S520, during the period from time t1 to time t2 (i.e., the second period), the gate driver circuit enables the transistor T2 and turns off the transistor T1, to charge the node N2 (i.e., the second node) to the voltage V2 (i.e., the second voltage) according to the data signal DSB_S (i.e., the second data signal). In detail, during the period from time t1 to time t2, the gate drive signal GSA_R is switched to the low voltage level VGL, and the gate drive signal GSB_R is maintained at the high voltage level VGH, so that the transistor T1 is operated in the turn-off state, and the transistor T2 is operated in the conduction state. During the period from time t1 to time t2, the data signal DSA_S is maintained at the voltage V1, and the data signal DSB_S is switched to the voltage V2. The voltage V1 may be the same as or different from the voltage V2. As such, the node voltage Vg provided by the node N2 is charged to the voltage V2 based on the data signal DSB_S, and the pixel voltage Vp provided by the node N1 is boosted to the voltage V3 based on the capacitor CS1. The voltage V3 may be, for example, the sum of the voltage V1 and the voltage V2.

In step S530, after time t3, the capacitor CS1 (i.e., the first capacitor) boosts the pixel voltage Vp of the node N1 from the voltage V1 to the third voltage V3 (i.e., the third voltage). In detail, after time t3, the gate drive signal GSA_R is switched to the low voltage level VGL, and the gate drive signal GSB_R is maintained at the low voltage level VGL, so that the transistors T1 and T2 are respectively operated in the turn-off state. As such, the pixel voltage Vp provided by the node N1 may be maintained at the voltage V3 based on the capacitor CS1.

It should be noted that time t0 to time t2 may be one horizontal period of the display device 100 during the display driving process. In some embodiments, the data signals DSA_S and DSB_S may respectively be voltage signals of -15V to +15V (volts), and the pixel voltage Vp may be boosted to -24V to +24V. Therefore, the pixel circuit 500 may be implemented with lower system driving cost, using low-voltage data signals DSA_S and DSB_S to enable the pixel voltage Vp to be rapidly charged to -24V to +24V (completed within one horizontal period).

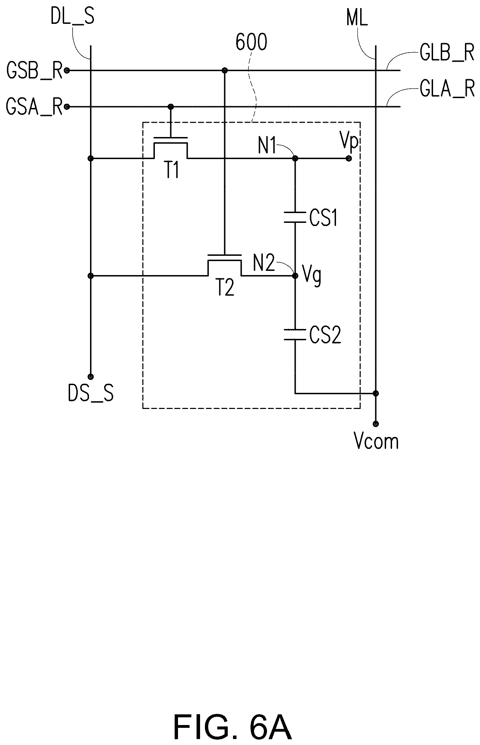

FIG. 6A is a schematic diagram of a pixel circuit according to another embodiment of the invention. Referring to FIG. 6A, in one embodiment, each of the pixel units P(1,1) to P(M,N) of FIG. 1 may have the circuit architecture of the pixel circuit 600 as shown in FIG. 6A. The pixel unit P(S,R) may include the pixel circuit 600, where S is a positive integer between 1 and M, and R is a positive integer between 1 and N. The pixel circuit 600 includes transistors T1, T2 and capacitors CS1, CS2. A first terminal of the transistor T1 is coupled to the data signal line DL_S to receive the data signal DS_S. A second terminal of the transistor T1 is coupled to the node N1. The node N1 is used to provide the pixel voltage Vp to the display unit. A control terminal of the transistor T1 is coupled to the gate signal line GLA_R to receive the gate drive signal GSA_R. A first terminal of the transistor T2 is coupled to the data signal line DL_S to receive the data signal DS_S. A second terminal of the transistor T2 is coupled to the node N2. The node N2 has a node voltage Vg. A control terminal of the transistor T2 is coupled to the gate signal line GLB_R to receive the gate drive signal GSB_R. The transistors T1, T2 are N-type transistors, but the invention is not limited thereto. In other embodiments, the transistors T1, T2 may also be designed as P-type transistors. A first terminal of the capacitor CS1 is coupled to the node N1. A second terminal of the capacitor CS1 is coupled to the node N2. A first terminal of the capacitor CS2 is coupled to the node N2. A second terminal of the capacitor CS2 is coupled to the reference signal line ML to receive the reference voltage Vcom. The reference voltage Vcom may be a common electrode voltage.

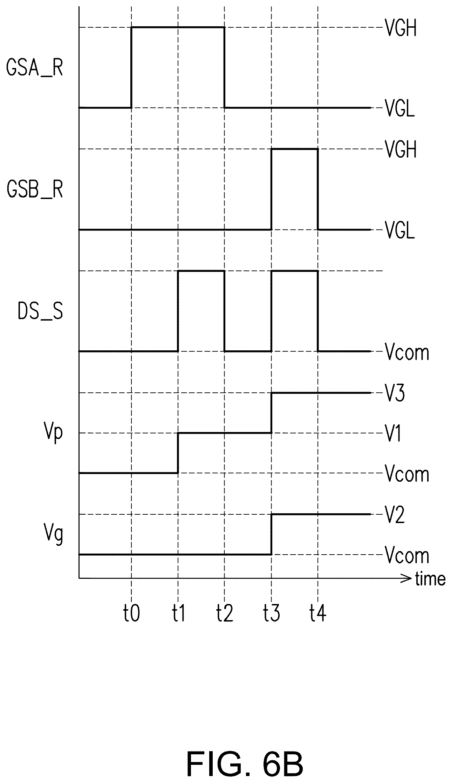

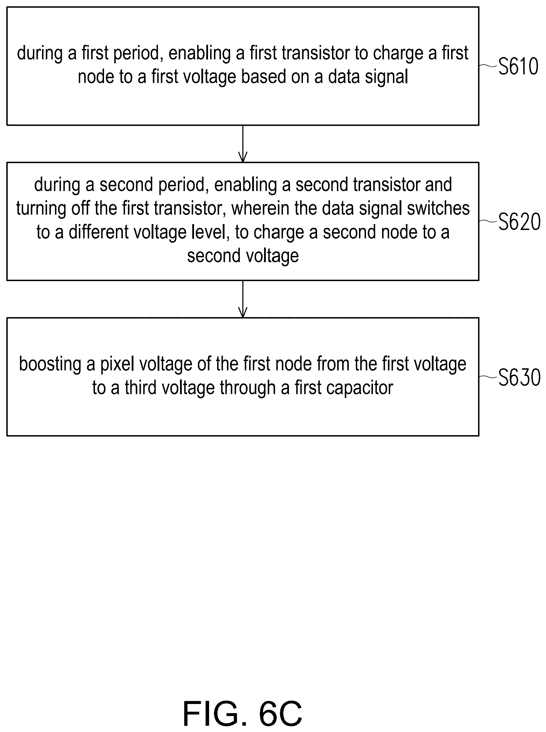

FIG. 6B is a timing diagram of multiple signals and voltages according to the embodiment of FIG. 6A of the invention. FIG. 6C is a flowchart of a driving method according to the embodiment of FIG. 6A of the invention. Referring to FIG. 6A to FIG. 6C, the pixel circuit 600 may generate the voltage variation of the pixel voltage Vp as shown in FIG. 6B based on the driving method of the embodiment of FIG. 6C. In step S610, during a period from time t0 to time t1 (i.e., a first period), the gate driver circuit enables the transistor T1 (i.e., the first transistor) to charge the node N1 (i.e., the first node) to voltage V1 (i.e., the first voltage) according to the data signal DS_S. In detail, during the period from time t0 to time t1 (e.g., a reset period), the gate drive signal GSA_R is switched to the high voltage level VGH, and the gate drive signal GSB_R is at the low voltage level VGL, so that the transistor T1 is operated in the conduction state, and the transistor T2 is operated in the turn-off state. The data signal DS_S is the reference voltage Vcom. As such, the pixel voltage Vp provided by the node N1 is reset to the reference voltage Vcom.

In step S620, during a period from time t1 to time t2 (i.e., a second period), the gate driver circuit enables the transistor T2 (i.e., the second transistor) and turns off the transistor T1, wherein the data signal DS_S switches to a different voltage level to charge the node N2 (i.e., the second node) to voltage V2 (i.e., the second voltage). In detail, during the period from time t1 to time t2, the data signal DS_S is switched to the high voltage level (e.g., the voltage V1). As such, the pixel voltage Vp provided by the node N1 may be charged to voltage V1 based on the data signal DS_S. During the period from time t2 to time t3, the gate drive signal GSA_R is switched to the low voltage level VGL, and the gate drive signal GSB_R is maintained at the low voltage level VGL, so that the transistors T1 and T2 are respectively operated in the turn-off state. As such, the pixel voltage Vp provided by the node N1 may be maintained at voltage V1 based on the capacitor CS1.

In step S630, during a period from time t3 to time t4, the capacitor CS1 (i.e., the first capacitor) boosts the pixel voltage Vp of the node N1 from the voltage V1 to the voltage V3 (i.e., the third voltage). In detail, during the period from time t3 to time t4, the gate drive signal GSA_R is switched to the low voltage level VGL, and the gate drive signal GSB_R is switched to the high voltage level VGH, so that the transistor T1 is operated in the turn-off state, and the transistor T2 is operated in the conduction state. During the period from time t3 to time t4, the data signal DS_S is switched to the high voltage level. As such, the node voltage Vg provided by the node N2 is charged to the voltage V2 based on the data signal DS_S, and the pixel voltage Vp provided by the node N1 is boosted to the voltage V3 based on the capacitor CS1. The voltage V3 may be, for example, a result of adding the voltage V1 and the voltage V2.

It should be noted that time t0 to time t4 may be one horizontal synchronization period (Horizontal Period) of the display device 100 during the display driving process. In some embodiments, the data signal DS_S may be a voltage signal of -15V to +15V (volts), and the pixel voltage Vp may be boosted to -24V to +24V. Therefore, the pixel circuit 600 may be implemented with lower system driving cost to rapidly charge the pixel voltage Vp to -24V to +24V (completed within one horizontal synchronization period) using the low-voltage data signal DS_S.

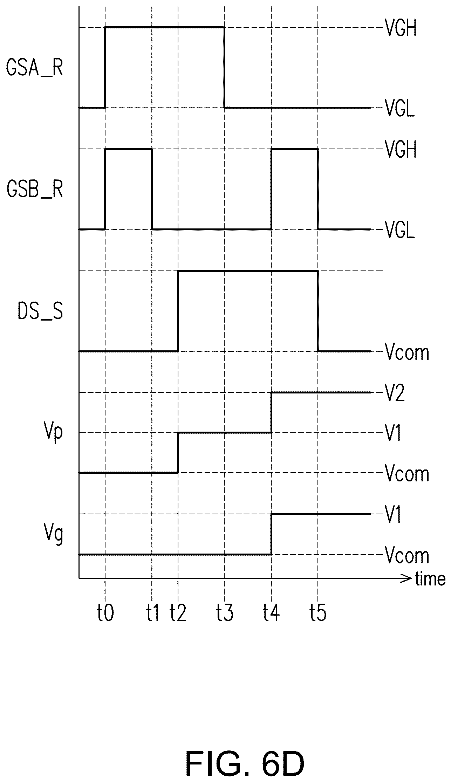

FIG. 6D is another timing diagram of multiple signals and voltages according to the embodiment of FIG. 6A of the invention. Referring to FIG. 6A and FIG. 6D, the pixel circuit 600 may generate the pixel voltage Vp based on the operation method of the embodiment of FIG. 6D. During a period from time t0 to time t1 (e.g., the reset period), the gate drive signal GSA_R and the gate drive signal GSB_R are respectively switched to the high voltage level VGH, so that the transistors T1 and T2 are respectively operated in the conduction state. The data signal DS_S is the reference voltage Vcom. As such, the pixel voltage Vp provided by the node N1 and the node voltage Vg provided by the node N2 may respectively be the reference voltage Vcom.

During a period from time t2 to time t3, the gate drive signal GSA_R is maintained at the high voltage level VGH, and the gate drive signal GSB_R is switched to the low voltage level VGL, so that the transistor T1 is operated in the conduction state, and the transistor T2 is operated in the turn-off state. The data signal DS_S is switched to a high voltage level (e.g., the voltage V1). As such, the pixel voltage Vp provided by the node N1 may be charged to the voltage V1 based on the data signal DS_S. During a period from time t3 to time t4, the gate drive signal GSA_R is switched to the low voltage level VGL, and the gate drive signal GSB_R is maintained at the low voltage level VGL, so that the transistors T1 and T2 are respectively operated in the turn-off state. As such, the pixel voltage Vp provided by the node N1 may be maintained at the voltage V1 based on the capacitor CS1.

Next, during a period from time t4 to time t5, the gate drive signal GSA_R is maintained at the low voltage level VGL, and the gate drive signal GSB_R is switched to the high voltage level VGH, so that the transistor T1 is operated in the turn-off state, and the transistor T2 is operated in the conduction state. During the period from time t4 to time t5, the data signal DS_S may be maintained at the same or different high voltage level. As such, the node voltage Vg provided by the node N2 is charged to the voltage V2 based on the data signal DS_S, and the pixel voltage Vp provided by the node N1 is boosted to the voltage V3 based on the capacitor CS1. The voltage V3 may be, for example, a result of adding the voltage V1 and the voltage V2.

It should be noted that time t0 to time t5 may be one horizontal synchronization period (Horizontal Period) of the display device 100 during the display driving process. In some embodiments, the data signal DS_S may be a voltage signal of -15V to +15V (volts), and the pixel voltage Vp may be boosted to -24V to +24V. Therefore, the pixel circuit 600 may be implemented with lower system driving cost, using the low-voltage data signal DS_S to enable the pixel voltage Vp to be rapidly charged to -24V to +24V (completed within one horizontal synchronization period).

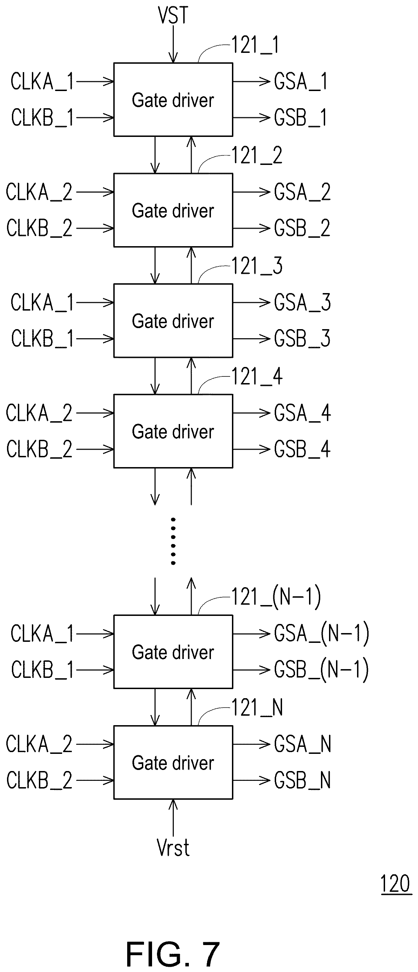

FIG. 7 is a schematic diagram of a gate driver circuit according to an embodiment of the invention. Referring to FIG. 1 and FIG. 7, the gate driver circuit 120 of FIG. 1 may include a plurality of gate drivers 121_1 to 121_N as shown in FIG. 7. The gate drivers 121_1 to 121_N are respectively coupled to different rows of the pixel units P(1,1) to P(M,N). Each of the gate drivers 121_1 to 121_N is respectively configured to receive two clock signals and to output two gate drive signals to a corresponding row of the pixel units P(1,1) to P(M,N). Specifically, the gate drivers 121_1, 121_3 to 121_(N-1) corresponding to odd rows may receive a first group of a clock signal CLKA_1 and a clock signal CLKB_1, and the gate drivers 121_2, 121_4 to 121_N corresponding to even rows may receive a second group of another clock signal CLKA_2 and another clock signal CLKB_2. The gate drivers 121_1 to 121_N may sequentially output gate drive signals GSA_1 to GSA_N and gate drive signals GSB_1 to GSB_N.

In one embodiment, each of the gate drivers 121_1 to 121_N may receive gate pulse voltages generated by the gate drivers of the preceding and following two stages, and may further generate two gate drive signals according to the two clock signals. Moreover, the gate pulse voltage generated by each of the gate drivers 121_1 to 121_N may be provided to the gate drivers of the preceding and following two stages. The gate driver 121_1 may further receive a start signal VST. The gate driver 121_N may further receive a reset signal Vrst.

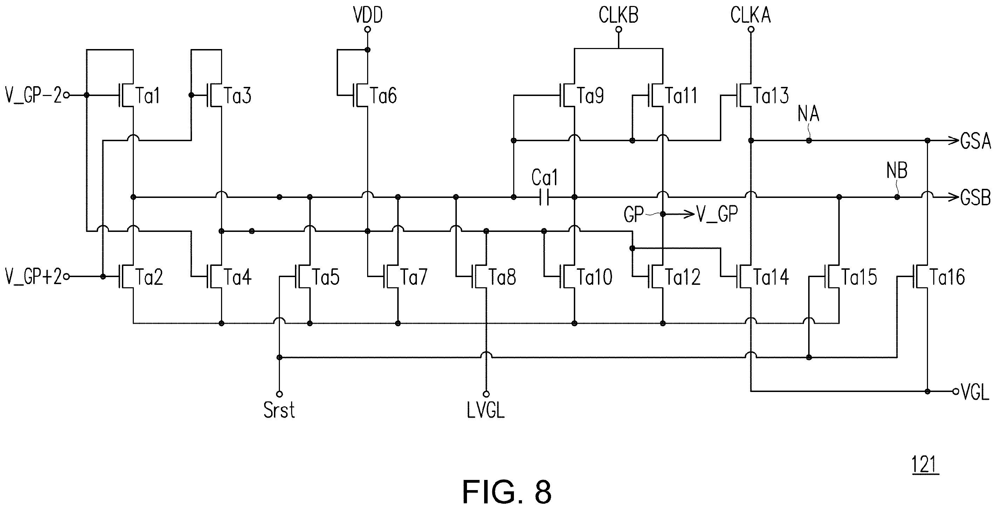

Specifically, referring to FIG. 8, FIG. 8 is a schematic diagram of a gate driver according to an embodiment of the invention. Each of the gate drivers 121_1 to 121_N of FIG. 7 may have a circuit architecture of the gate driver 121 as shown in FIG. 8 (the first-stage gate driver 121_1 and the last-stage gate driver 121_N may be different). The gate driver 121 includes transistors Ta1 to Ta16 and a capacitor Ca1. The transistors Ta1 to Ta16 may be N-type transistors, but the invention is not limited thereto. A first terminal of the transistor Ta1 is coupled to a control terminal of the transistor Ta4. A second terminal of the transistor Ta1 is coupled to a first terminal of the capacitor Ca1, first terminals of the transistors Ta2, Ta5, Ta7, and control terminals of the transistors Ta8, Ta9, Ta11, Ta13. A control terminal of the transistor Ta1 may receive a gate pulse voltage V_GP-2 of a gate driver of the preceding two stages. A second terminal of the transistor Ta2 is coupled to second terminals of the transistors Ta4, Ta5, Ta7, Ta8, Ta10, Ta12, Ta14, Ta15. A control terminal of the transistor Ta2 may receive a gate pulse voltage V_GP+2 of a gate driver of the following two stages. A first terminal of the transistor Ta3 is coupled to a control terminal of the transistor Ta3 and a control terminal of the transistor Ta2. A second terminal of the transistor Ta3 is coupled to first terminals of the transistors Ta4, Ta8, and control terminals of the transistors Ta6, Ta7, Ta10, Ta12, Ta14.

A control terminal of the transistor Ta5 receives a reset signal Srst. A first terminal of the transistor Ta6 is coupled to a control terminal of the transistor Ta6 and an operation voltage VDD. A second terminal of the transistor Ta8 receives a reference voltage LVGL. A first terminal of the transistor Ta9 receives a clock signal CLKB. A second terminal of the transistor Ta9 is coupled to a first terminal of the transistor Ta10. A first terminal of the transistor Ta11 receives a clock signal CLKB. A second terminal of the transistor Ta11 is coupled to a first terminal of the transistor Ta12 and a node GP. A first terminal of the transistor Ta13 receives a clock signal CLKA. A second terminal of the transistor Ta13 is coupled to a node NA and a first terminal of the transistor Ta14. A second terminal of the transistor Ta14 receives a reference voltage VGL. A first terminal of the transistor Ta15 is coupled to a second terminal of the capacitor Ca1 and a node NB. A control terminal of the transistor Ta15 receives a reset signal Srst. A first terminal of the transistor Ta14 is coupled to the node NA. A control terminal of the transistor Ta16 receives a reset signal Srst. A second terminal of the transistor Ta16 receives a reference voltage VGL. In one embodiment, the node GP is configured to output a gate pulse voltage V_GP. The node NA is configured to output a gate drive signal GSA. The node NB is configured to output a gate drive signal GSB.

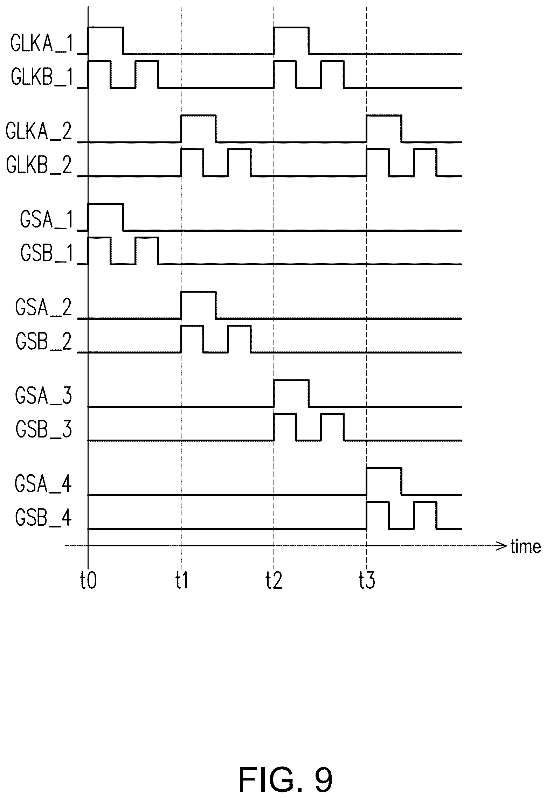

FIG. 9 is a timing diagram of multiple clock signals and multiple gate drive signals according to the embodiment of FIG. 7 of the invention. Referring to FIG. 7 and FIG. 9, taking gate drivers 121_1 to 121_4 as an example, gate drivers 121_1, 121_3 may receive the clock signal CLKA_1 and the clock signal CLKB_1, and gate drivers 121_2, 121_4 may receive the clock signal CLKA_2 and the clock signal CLKB_2. The gate drivers 121_1 to 121_4 may respectively generate a plurality of gate drive signals GSA_1 to GSA_4 and a plurality of gate drive signals GSB_1 to GSB_4 as shown in FIG. 9 based on the circuit architecture of FIG. 8 above and according to the operation of corresponding clock signals. During the time from time t0 to time t1, the gate driver 121_1 may output the gate drive signal GSA_1 and the gate drive signal GSB_1, wherein the waveform relationship of the gate drive signal GSA_1 and the gate drive signal GSB_1 may correspond to the gate drive signal GSA_R and the gate drive signal GSB_R of the embodiment of FIG. 6D above, therefore no further elaboration is provided. Moreover, the waveform relationships of the gate drive signals GSA_2 to GSA_4 and the gate drive signals GSB_2 to GSB_4 output by the gate drivers 121_2 to 121_4 may also be analogized.

In summary, the pixel circuit of the display device and driving method thereof of the invention may rapidly generate high pixel voltage according to low data voltage to effectively drive high voltage display elements. In one embodiment, the pixel circuit may perform two-stage boost control through a circuit design having two bootstrap capacitors and five transistors, and in conjunction with different gate drive signals provided by three gate signal lines. In another embodiment, the pixel circuit may achieve boost function through a simplified architecture of two transistors with two capacitors in a manner of lower component cost. Moreover, the display device of the invention may be combined with a gate driver circuit to implement the aforementioned functions.

## Claims

1. A display device (100), comprising:
a pixel array (110), comprising a plurality of pixel units (P(1,1) to P(M,N)), wherein each of the plurality of pixel units (P(1,1) to P(M,N)) comprises:
a first bootstrap capacitor (Cboost1), coupled to a first node (N1);
a second bootstrap capacitor (Cboost2), coupled to the first node (N1) and a second node (N2);
a storage capacitor (Cst), coupled to the second node (N2);
a first transistor (T1), coupled to the first node (N1);
a second transistor (T2), coupled to the first bootstrap capacitor (Cboost1);
a third transistor (T3), coupled to a second terminal of the first transistor (T1), the second transistor (T2), and the first bootstrap capacitor (Cboost1);
a fourth transistor (T4), coupled to the second node (N2) and the storage capacitor (Cst); and
a fifth transistor (T5), coupled to the first transistor (T1), a first terminal of the third transistor (T3), and the second node (N2);
wherein the pixel unit (P(1,1) to P(M,N)) is configured to perform in an update operation:
during a charging period, applying a data voltage to the first node (N1);
during a first boost period, through switching a terminal of the first bootstrap capacitor (Cboost1) from a reference voltage (Vcom) to the data voltage, and through capacitive coupling causing a pixel voltage (Vp) of the first node (N1) to undergo a first boost or pull-down;
during a second boost period, through switching a terminal of the second bootstrap capacitor (Cboost2) from the reference voltage (Vcom) to the data voltage, and through capacitive coupling causing the pixel voltage (Vp) of the first node (N1) to undergo a second boost or pull-down; and
during a maintaining period, maintaining the pixel voltage (Vp) of the first node (N1).

2. The display device (100) according to claim 1, wherein a first terminal of the first transistor (T1) is coupled to the first node (N1), a second terminal of the first transistor (T1) is coupled to a data signal line (DL) to receive a data signal (DS), and a control terminal of the first transistor (T1) is coupled to a first gate signal line (SL1).

3. The display device (100) according to claim 2, wherein a first terminal of the first bootstrap capacitor (Cboost1) is coupled to a first terminal of the second transistor (T2), and a second terminal of the first bootstrap capacitor (Cboost1) is coupled to the first node (N1).

4. The display device (100) according to claim 3, wherein a second terminal of the second transistor (T2) receives a reference voltage (Vcom), and a control terminal of the second transistor (T2) is coupled to the first gate signal line (SL1).

5. The display device (100) according to claim 4, wherein a first terminal of the third transistor (T3) is coupled to the data signal line (DL) to receive the data signal (DS), a second terminal of the third transistor (T3) is coupled to the first terminal of the second transistor (T2) and the first terminal of the first bootstrap capacitor (Cboost1), and a control terminal of the third transistor (T3) is coupled to a second gate signal line (SL2).

6. The display device (100) according to claim 5, wherein a first terminal of the second bootstrap capacitor (Cboost2) is coupled to the first node (N1), and a second terminal of the second bootstrap capacitor (Cboost2) is coupled to a second node (N2).

7. The display device (100) according to claim 5, wherein a first terminal of the fourth transistor (T4) is coupled to the second node (N2), a second terminal of the fourth transistor (T4) is coupled to a first terminal of the storage capacitor (Cst), and a control terminal of the fourth transistor (T4) is coupled to the second gate signal line (SL2).

8. The display device (100) according to claim 5, wherein a first terminal of the fifth transistor (T5) is coupled to the data signal line (DL) to receive the data signal (DS), a second terminal of the fifth transistor (T5) is coupled to the second node (N2), and a control terminal of the fifth transistor (T5) is coupled to a third gate signal line (SL3).

9. The display device (100) according to claim 8, wherein the first gate signal line (SL3), the second gate signal line (SL2), and the third gate signal line (SL3) are respectively configured to transmit different gate drive signals (GS1 to GS3),
wherein pulse periods of the different gate drive signals (GS1 to GS3) are respectively non-overlapping.

10. The display device (100) according to claim 1, wherein the first transistor (T1), the second transistor (T2), the third transistor (T3), the fourth transistor (T4), and the fifth transistor (T5) are N-type transistors.

11. The display device (100) according to claim 1, wherein when the data voltage is positive, the first boost and the second boost increase the pixel voltage (Vp),
wherein when the data voltage is negative, the first pull-down and the second pull-down decrease the pixel voltage (Vp).

12. The display device (100) according to claim 1, wherein after the second boost or the second pull-down, an absolute value of the pixel voltage (Vp) is greater than an absolute value of the data voltage.

13. The display device (100) according to claim 1, wherein the display device (100) is a bistable display.

14. The display device (100) according to claim 1, wherein the reference voltage (Vcom) comprises at least one common potential and/or one bias potential, and the reference voltage (Vcom) is configured to provide to switching terminals of the first bootstrap capacitor (Cboost1) and the second bootstrap capacitor (Cboost2) during respective boost periods.

15. The display device (100) according to claim 1, wherein the pixel unit (P(1,1) to P(M,N)) is configured to repeatedly perform the capacitive coupling boost to form at least three voltage boosts or voltage pull-downs.

16. A driving method, wherein the driving method is applied to a display device (100) comprising a pixel array (110), the pixel array (110) comprises a plurality of pixel units (P(1,1) to P(M,N)), and each of the plurality of pixel units (P(1,1) to P(M,N)) comprises a first node (N1), a second node (N2), a first bootstrap capacitor (Cboost1), a second bootstrap capacitor (Cboost2), and a storage capacitor (Cst), wherein the driving method comprises:
performing an update operation on each of the plurality of pixel units (P(1,1) to P(M,N)), wherein the update operation comprises:
during a charging period, enabling a first gate drive signal (GS1) to write a data voltage into the first node (N1);
during a first boost period, enabling a second gate drive signal (GS2) and setting a data signal line (DL) to a fixed voltage, to cause a first boost or pull-down of a pixel voltage (Vp) of the first node (N1) through switching a terminal of the first bootstrap capacitor (Cboost1) from a reference voltage (Vcom) to the data voltage and through capacitive coupling;
during a second boost period, enabling a third gate drive signal (GS3) and maintaining the data signal line (DL) at the fixed voltage, to cause a second boost or pull-down of the pixel voltage (Vp) of the first node (N1) through switching a terminal of the second bootstrap capacitor (Cboost2) from the reference voltage (Vcom) to the data voltage and through capacitive coupling; and
during a maintaining period, turning off the first gate drive signal (GS1), the second gate drive signal (GS2), and the third gate drive signal (GS3) to maintain the pixel voltage (Vp) of the first node (N1).
